# EUROPEAN PATENT APPLICATION

(11) **EP 4 658 033 A1**
(43) Date of publication of application: **03.12.2025**
(21) Application number: 25178558.0
(22) Date of filing: 23.05.2025
(51) Int. Cl.: H10H 20/816

(54) **SEMICONDUCTOR DEVICE**

(30) Priority: 24.05.2024 US 202418674348
(71) Applicant: Epistar Corporation, Hsinchu 300 (TW)
(72) Inventor: LIN, Yi-Chieh, 300 Hsinchu (TW); TSAI, Yi Shan, 300 Hsinchu (TW); WANG, Yi-Hung, 300 Hsinchu (TW); YEOH, Wei Shan, 300 Hsinchu (TW); HU, Dian-Ying, 300 Hsinchu (TW); LEE, Shih-Chang, 300 Hsinchu (TW)
(74) Representative: Ter Meer Steinmeister & Partner

(57) **Abstract**

A semiconductor device is provided, which includes a base, a semiconductor stack located on the base, and a first semiconductor layer located on the semiconductor stack. The semiconductor stack includes a first semiconductor structure adjacent to the base, a second semiconductor structure located on the first semiconductor structure, and a first active region located between the first semiconductor structure and the second semiconductor structure. The first semiconductor layer is located on the second semiconductor structure, and includes Alₙ₁Ga₁₋ₙ₁As, where 0.005≤n1<0.2. And the first semiconductor structure has a second thickness in a range of 3 µm to 8 µm. The semiconductor device outputs a first power corresponding to a light with a wavelength equal to or larger than 900 nm and less than 1100nm, and a second power corresponding to a light with a wavelength less than 900 nm and larger than 700 nm. A ratio of the second power to a sum of the first power and the second power is equal to or less than 30%.

## Description

### Field of Disclosure

The present disclosure relates to a semiconductor device, in particular to a semiconductor optoelectronic device such as a light-emitting device.

### Background of the Disclosure

A III-V semiconductor material containing a group III element and a group V element may be applied to various optoelectronic devices, such as light emitting diodes (LEDs), laser diodes (LDs), photoelectric detectors, solar cells or power devices (such as switches or rectifiers). These optoelectronic devices can be applied in various fields, such as illumination, medical care, display, communication, sensing, or power supply system. For example, in the light-emitting devices, LEDs have low energy consumption and long operating lifetime, and are widely used.

### Summary of the Disclosure

The present disclosure provides a semiconductor device. The semiconductor device includes a base, a semiconductor stack located on the base, and a first semiconductor layer located on the semiconductor stack. The semiconductor stack includes a first semiconductor structure adjacent to the base, a second semiconductor structure located on the first semiconductor structure, and a first active region located between the first semiconductor structure and the second semiconductor structure. The first semiconductor layer is located on the second semiconductor structure, and includes Alₙ₁Ga₁₋ₙ₁As, where 0.005≤n1<0.2. And the first semiconductor structure has a second thickness in a range of 3 µm to 8 µm. The semiconductor device outputs a first power corresponding to a light with a wavelength equal to or larger than 900 nm and less than 1100nm, and a second power corresponding to a light with a wavelength less than 900 nm and larger than 700 nm. A ratio of the second power to a sum of the first power and the second power is equal to or less than 30%.

In one or more embodiments, the semiconductor device may further comprise a second semiconductor layer located between the first semiconductor layer and the second semiconductor structure.

In one or more embodiments, the second semiconductor layer may be devoid of aluminum and has a second thickness in a range of 1 µm to 8 µm.

In one or more embodiments, each of the plurality of first well layers may have a thickness in a range of 2 nm to 20 nm.

In one or more embodiments, the semiconductor stack may further comprise a third semiconductor structure located between the first semiconductor layer and the second semiconductor structure, a fourth semiconductor structure located between the first semiconductor layer and the third semiconductor structure, and a second active region located between the third semiconductor structure and the fourth semiconductor structure.

In one or more embodiments, the second active region may comprise a plurality of second barrier layers and a plurality of second well layers which are alternately stacked with each other.

In one or more embodiments, the first active region may comprise a first zone and a second zone located between the first zone and the first semiconductor structure.

In one or more embodiments, both the first zone and the second zone may comprise the first barrier layer and the first well layer

In one or more embodiments, the first well layer in the second zone may have a thickness larger than that of the first well layer in the first zone.

In one or more embodiments, a ratio of the thickness of the first well layer in the second zone to the thickness of the first well layer in the first zone may be in a range of 1.5 to 3.

In one or more embodiments, the first active region may comprise a first zone and a second zone located between the first zone and the first semiconductor structure.

In one or more embodiments, the second zone may comprise 2 to 5 pairs of the first barrier layer and the first well layer.

In one or more embodiments, the first well layer in the second zone may have a thickness larger than that of the first well layer in the first zone.

In one or more embodiments, the first zone may directly connect the second zone.

In one or more embodiments, the first well layer in the first zone and the second well layer in the second zone may have the same material composition.

In one or more embodiments, each of the plurality of first well layers may comprises indium.

In one or more embodiments, each of the plurality of first well layers may have an indium content which is in a range of 0.02 to 0.4.

In one or more embodiments, each of the plurality of first barrier layers may comprise aluminum.

In one or more embodiments, each of the plurality of first barrier layers may have an aluminum content which has a gradient variation.

In one or more embodiments, the semiconductor device may further comprise a reflective structure disposed between the first semiconductor structure and the base.

In one or more embodiments, the semiconductor device may further comprise an insulating structure disposed between the reflective structure and the first semiconductor structure.

In one or more embodiments, the semiconductor device may further comprise a metal oxide layer disposed between the insulating structure and the reflective structure.

In one or more embodiments, the insulating structure may comprise a plurality of holes.

In one or more embodiments, the metal oxide layer may connect the first semiconductor structure through the plurality of holes.

In another aspect a package structure is provided, comprising: a package substrate; the semiconductor device as described above and disposed on the package substrate; and an encapsulating structure covering the semiconductor device.

### Brief Description of the Drawings

FIG. 1A shows a schematic top view of a semiconductor device in accordance with some embodiments of the present disclosure.
FIG.1B is a schematic sectional view of the semiconductor device along line A-A' in FIG. 1A.
FIG. 1C is an enlarged sectional view of a region R1 of the semiconductor device in FIG. 1B.
FIG. 1D shows a schematic sectional view of a first active region in accordance with some embodiments of the present disclosure.
FIG. 2A shows a schematic sectional view of a semiconductor device in accordance with some embodiments of the present disclosure.
FIG. 2B is an enlarged sectional view of a region R2 of the semiconductor device in FIG. 2A.
FIG. 2C shows a schematic sectional view of a second active region in accordance with some embodiments of the present disclosure.
FIG. 3 is a graph showing light emission spectrums of semiconductor devices with different aluminum contents in accordance with an embodiment of the present disclosure.
FIG. 4 is a graph showing light emission spectrums of semiconductor devices with different well layers thicknesses in accordance with an embodiment of the present disclosure.
FIG. 5 shows a graph showing light emission spectrums of semiconductor devices with and without a second semiconductor layer of an embodiment of the present disclosure.
FIG. 6 shows a schematic sectional view of a package structure in accordance with an embodiment of the present disclosure.
FIG. 7 shows a graph showing light emission spectrums of semiconductor devices with different thickness configuration of well layer of an embodiment of the present disclosure.

### Detailed Description of the Disclosure

The following embodiments will be described with accompany drawings to disclose the concept of the present disclosure. In the drawings or description, same or similar portions are indicated with same or similar numerals. Furthermore, a shape or a size of a member in the drawings may be enlarged or reduced. Particularly, it should be noted that a member which is not illustrated or described in drawings or description may be in a form that is known by a person skilled in the art.

In the present disclosure, if not otherwise specified, the general formula InGaP represents Inₓ₀Ga₁₋ₓ₀P, wherein 0<x0<1; the general formula AlInP represents Alₓ₁In₁₋ₓ₁P, wherein 0<x1<1; the general formula AlGaInP represents Alₓ₂Gaₓ₃In₁₋ₓ₂₋ₓ₃P, wherein 0<x2<1 and 0<x3<1; the general formula InGaAsP represents Inₓ₄Ga₁₋ₓ₄Asₓ₅P₁₋ₓ₅, wherein 0<x4<1 ^{,} 0<x5<1; the general formula AlGaInAs represents Alₓ₆Gaₓ₇In₁₋ₓ₆₋ₓ₇As, wherein 0<x6<1 and 0<x7<1; the general formula InGaAs represents Inₓ₈Ga₁₋ₓ₈As, wherein 0<x8<1; the general formula AlGaAs represents Alₓ₉Ga₁₋ₓ₉As, wherein 0<x9<1; the general formula InGaN represents Inₓ₁₀Ga₁₋ₓ₁₀N, wherein 0<x10<1; the general formula AlGaN represents Alₓ₁₁Ga₁₋ₓ₁₁N, wherein 0<x11<1; the general formula AlGaAsP represents Alₓ₁₂Ga₁₋ₓ₁₂Asₓ₁₃P₁₋ₓ₁₃, wherein 0<x12<1 and 0<x13<1; the general formula InGaAsN represents Inₓ₁₄Ga₁₋ₓ₁₄Asₓ₁₅N₁₋ₓ₁₅, wherein 0<x14<1 and 0<x15<1; the general formula AlInGaN represents Alₓ₁₆Inₓ₁₇Ga₁₋ₓ₁₆₋ₓ₁₇N, wherein 0<x16<1 and 0<x17<1. The content of each element may be adjusted for different purposes, such as for adjusting the energy gap, or the peak wavelength or peak wavelength when the semiconductor device is a light-emitting device.

The semiconductor device of the present disclosure is a light-emitting device (such as a light-emitting diode or a laser diode), a light absorbing device (such as a photo-detector) or a non-optoelectronic device. Analysis of the composition and/or dopant contained in each layer of the semiconductor device of the present disclosure may be conducted by any suitable method such as a secondary ion mass spectrometer (SIMS) or an energy dispersive X-ray spectrometer (EDX). A thickness of each layer may be obtained by any suitable method, such as a transmission electron microscopy (TEM) or a scanning electron microscope (SEM).

A person skilled in the art can realize that addition of other components based on a structure recited in the following embodiments is allowable. For example, if not otherwise specified, a description similar to "a first layer/structure is on or under a second layer/structure" may include an embodiment in which the first layer/structure directly (or physically) contacts the second layer/structure, and may also include an embodiment in which another structure is provided between the first layer/structure and the second layer/structure, such that the first layer/structure and the second layer/structure do not physically contact each other. In addition, it should be realized that a positional relationship of a layer/structure may be altered when being observed in different orientations.

Furthermore, in the present disclosure, a description of "a layer/structure only includes M material" means the M material is the main constituent of the layer/structure; however, the layer/structure may still contain a dopant or unavoidable impurities.

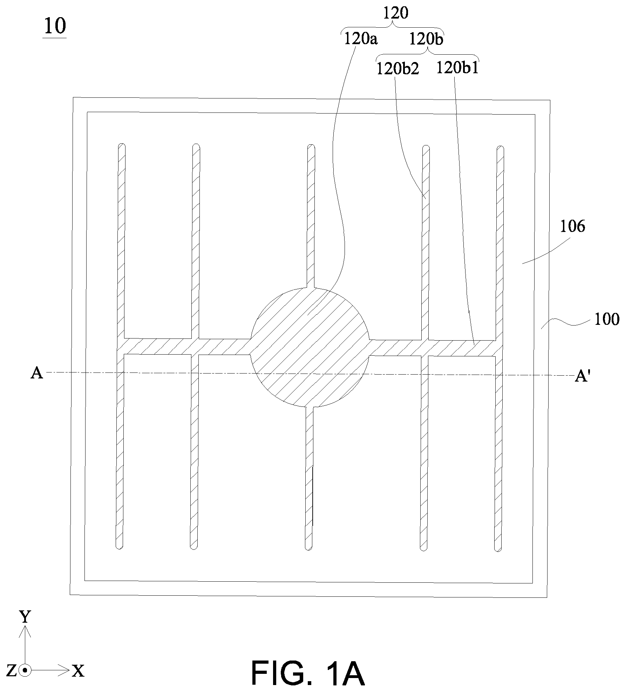

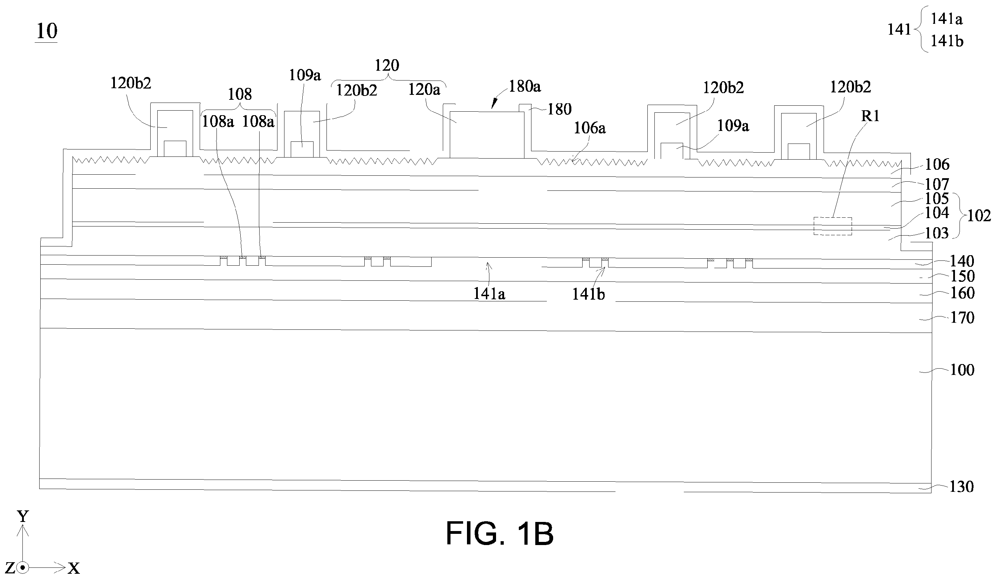

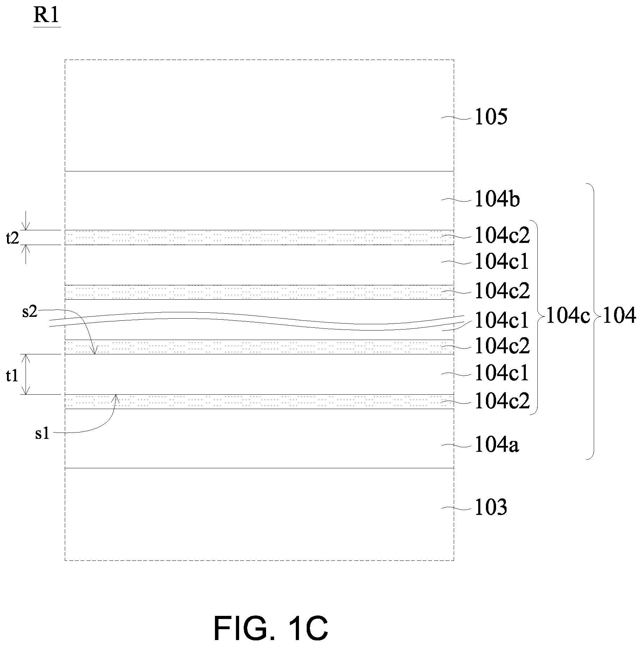

FIG. 1A shows a schematic top view of a semiconductor device 10 in accordance with some embodiments of the present disclosure. FIG. 1B shows a schematic sectional view of the semiconductor device 10 along the line A-A' in FIG. 1A. FIG. 1C shows an enlarged sectional view of a region R1 in FIG. 1B.

As shown in FIGS. 1A and 1B, the semiconductor device 10 includes a base 100, a semiconductor stack 102, a first electrode 120, a second electrode 130 and a first semiconductor layer 106. The semiconductor stack 102 is located on the base 100. The first semiconductor layer 106 is located on a side of the semiconductor stack 102 away from the base 100. The first electrode 120 is located on the first semiconductor layer 106, and the second electrode 130 is located under the base 100. In addition, the semiconductor device 10 may further optionally include an insulating structure 140, a conductive structure 150, a reflective structure 160, a bonding structure 170 and/or a protecting structure 180.

As shown in FIG. 1A, the first electrode 120 includes an electrode pad 120a and optionally includes an electrode extension 120b connected to the electrode pad 120a. In some embodiments, the electrode extension 120b includes a first extension portion 120b1 and a second extension portion 120b2. The first extension portion 120b1 is in direct contact with the electrode pad 120a, and the second extension portion 120b2 is in direct contact with the first extension portion 120b1 and extends in a direction perpendicular to the first extension portion 120b1. The first extension portion 120b1 have a width greater than or equal to a width of the second extension portion 120b2. In some embodiments, the width of the first extension portion 120b1 can be gradually changed (not shown). For example, the width of the first extension portion 120b1 is gradually increased in a direction toward the electrode pad 120a, and is gradually decreased in a direction away from the electrode pad 120a. In this embodiment, the semiconductor device 10 may only have one electrode pad 120a. In some embodiments, the semiconductor device 10 may have two or more electrode pads 120a (not shown).

The first electrode 120 and the second electrode 130 provide electrical connections to an external power supply. The materials of the first electrode 120 and the second electrode 130 may be the same or different. For example, the materials of the first electrode 120 and the second electrode 130 include a metal oxide, a metal or an alloy. The metal oxide includes indium tin oxide (ITO), indium oxide (InO), tin oxide (SnO), cadmium tin oxide (CTO), antimony tin oxide (ATO), aluminum zinc oxide (AZO), zinc tin oxide (ZTO), gallium zinc oxide (GZO), indium tungsten oxide (IWO), zinc oxide (ZnO) or indium zinc oxide (IZO), indium cerium oxide(ICO), indium titanium oxide (ITiO), indium gallium oxide(IGO) or gallium aluminum zinc oxide (GAZO). The metal may include germanium (Ge), beryllium (Be), zinc (Zn), gold (Au), platinum (Pt), titanium (Ti), aluminum (Al), nickel (Ni), tin (Sn) or copper (Cu). The alloy includes two or more of the above metals, such as germanium gold nickel (GeAuNi), beryllium gold (BeAu), germanium gold (GeAu) or zinc gold (ZnAu).

The base 100 includes conductive or insulating materials. The conductive materials include gallium arsenide (GaAs), indium phosphide (InP), silicon carbide (SiC), gallium phosphide (GaP), zinc oxide (ZnO), gallium nitride (GaN), aluminum nitride (AlN), germanium (Ge) or silicon (Si). The insulating material includes sapphire. In some embodiments, the base 100 is a growth substrate, that is, the semiconductor stack 102 can be formed on the base 100 by epitaxial methods such as metal-organic chemical vapor deposition (MOCVD), molecular beam epitaxy (MBE) or hydride vapor phase epitaxy (HVPE). In this embodiment, the base 100 is a bonding substrate instead of the growth substrate, and the base 100 can be bonded to the semiconductor stack 102 by the bonding structure 170.

The semiconductor stack 102 includes a first semiconductor structure 103 adjacent to the base 100, a second semiconductor structure 105 away from the base 100, and a first active region 104 located between the first semiconductor structure 103 and the second semiconductor structure 105. The first semiconductor structure 103 and the second semiconductor structure 105 may respectively be a single layer or multiple layers, and may be a cladding layer to limit the recombination of electron-hole pairs to occur in the first active region 104. The first semiconductor structure 103 and the second semiconductor structure 105 have different conductivity types. For example, the first semiconductor structure 103 is n-type and the second semiconductor structure 105 is p-type, or the first semiconductor structure 103 is p-type and the second semiconductor structure 105 is n-type. Thereby, the first semiconductor structure 103 and the second semiconductor structure 105 can respectively provide electrons and holes, or holes and electrons. The p-type conductivity can be obtained by adding dopant such as carbon (C), zinc (Zn), beryllium (Be) or magnesium (Mg). The n-type conductivity can be obtained by adding dopant such as silicon (Si), germanium (Ge), tin (Sn), selenium (Se) or tellurium (Te). In some embodiments, the first semiconductor structure 103 and/or the second semiconductor structure 105 may have a doping concentration in a range of 1x10¹⁶/cm³ to 5x10¹⁸/cm³. The first semiconductor structure 103 and the second semiconductor structure 105 may have the same or different thicknesses. In some embodiments, the first semiconductor structure 103 and/or the second semiconductor structure 105 respectively have a thickness equal to or less than 1 µm for lowering a total thickness of the semiconductor device 10 which is suitable for the miniaturized application. In some embodiments, the thickness of the first semiconductor structure 103 and/or the thickness of the second semiconductor structure 105 may be 0.1 µm, 0.3 µm, 0.5 µm, or 0.7 µm.

The first semiconductor structure 103, the second semiconductor structure 105, and/or the first active region 104 may include a III-V semiconductor material. The III-V semiconductor material may include aluminum (Al), gallium (Ga), arsenic (As), phosphorus (P), nitrogen (N), or indium (In). In some embodiments, the first semiconductor structure 103, the second semiconductor structure 105, and the first active region 104 may not contain nitrogen (N). Specifically, the III-V semiconductor material can be a binary compound semiconductor (such as GaAs, GaP or GaN), a ternary compound semiconductor (such as InGaAs, AlGaAs, InGaP, AlInP, InGaN or AlGaN) or a quaternary compound semiconductor (such as AlGaInAs, AlGaInP, AlInGaN, InGaAsP, InGaAsN or AlGaAsP). In some embodiments, the first active region 104 only include a ternary compound semiconductor (such as InGaAs, AlGaAs, InGaP, AlInP, InGaN, or AlGaN) or a quaternary compound semiconductor (such as AlGaInAs, AlGaInP, AlInGaN, InGaAsP, InGaAsN, or AlGaAsP).

The semiconductor stack 102 may include a single heterostructure (SH), a double heterostructure (DH), a double-side double heterostructure (DDH) or a multiple quantum well (MQW) structure. According to some embodiments, when the semiconductor device 10 is a light-emitting device, the first active region 104 may emit a light during the operation of the semiconductor device 10, and the semiconductor device 10 output a power. The light includes visible light and/or invisible light. The light emission of the semiconductor device 10 has a peak wavelength determined by the material composition of the first active region 104. For example, when the material of the first active region 104 includes InGaN, it may emit a blue light or a deep blue light with a peak wavelength of 400 nm to 490 nm, a green light with a peak wavelength of 490 nm to 550 nm or a red light with a peak wavelength of 560 nm to 650 nm; when the material of the first active region 104 includes AlGaN, it may emit ultraviolet light with a peak wavelength of 250 nm to 400 nm; when the material of the first active region 104 includes InGaAs, InGaAsP, AlGaAs or AlGaInAs, it may emit an infrared light with a peak wavelength of 700 to 1700 nm; when the material of the first active region 104 includes InGaP or AlGaInP, it may emit a red light with a peak wavelength of 610 nm to 700 nm, or a yellow light with a peak wavelength of 530 nm to 600 nm.

The first active region 104 is undoped or unintentionally doped. When the first active region 104 is unintentionally doped, a doping concentration of the first active region 104 may be less than 1x10¹⁶/cm³. Referring to FIG. 1C, the first active region 104 may include a first confinement layer 104a adjacent to the first semiconductor structure 103, a second confinement layer 104b adjacent to the second semiconductor structure 105, and a first active layer 104c located between the first confinement layer 104a and the second confinement layer 104b. The first active layer 104c includes a first barrier layer 104c1 and a first well layer 104c2. In some embodiments, the first active layer 104c include a plurality of the first barrier layers 104c1 and a plurality of first well layers 104c2 which are alternately stacked together. In some embodiments, the first active layer 104c may have 3 pairs to 18 pairs of first barrier layer 104c1 and first well layer 104c2. The first well layer 104c2 is disposed between two adjacent first barrier layers 104c1, between the first barrier layer 104c1 and the first confinement layer 104a or between the first barrier layer 104c1 and the second confinement layer 104b.

In some embodiments, the first well layer 104c2 may be a semiconductor material including indium (In), such as Inₐ₁Ga₁₋ₐ₁As, Alₐ₂Ga₁₋ₐ₁₋ₐ₂Inₐ₁As or Inₐ₁Ga₁₋ₐ₁AsP, so the first active region 104 emits the light with a peak wavelength between 900 nm to 1000 nm. "a1" represents the indium content of first well layer 104c2. In some embodiments, the indium content a1 of the first well layer 104c2 may be a fixed value, and may be in a range of 0.02 and 0.4. In some embodiments, the first confinement layer 104a, the second confinement layer 104b and/or the first barrier layer 104c1 may be AlInP, InGaP, AlGaAs, AlGaAsP or AlGaInP. The first confinement layer 104a, the second confinement layer 104b and/or the first barrier layer 104c1 have a band gap greater than that of the first well layer 104c2. When the first confinement layer 104a, the second confinement layer 104b and/or the first barrier layer 104c1 include aluminum (Al) (e.g., Alₐ₃Ga₁₋ₐ₃As), the band gaps of the first confinement layer 104a, the second confinement layer 104b and/or the first barrier layer 104c1 may be enlarged by increasing aluminum content a3 so as to improve the ability of confining electrons and enhance quantum efficiency (such as external quantum efficiency (EQE) or internal quantum efficiency (IQE)) of the semiconductor device 10. In some embodiments, the aluminum content a3 of the first confinement layer 104a, the second confinement layer 104b and/or the first barrier layer 104c1 can be a fixed value. Specifically, the indium content represents the ratio of indium to all the group III elements, and the aluminum content represents the ratio of aluminum to all the group III elements. For example, when the first confinement layer 104a (or the second confinement layer 104b or the first barrier layer 104c1) includes Alₐ₁Ga₁₋ₐ₁As, a1 represents the aluminum content of the first confinement layer 104a. The aluminum content of the first confinement layer 104a, the second confinement layer 104b and the first barrier layer 104c1 can be obtained by analyzing techniques such as EDX or SIMS.

In some embodiments, the aluminum content of the first confinement layer 104a and/or the second confinement layer 104b may have a gradient variation. For example, the aluminum content of the first confinement layer 104a may gradually increase from a side close to the first well layer 104c2 to another side close to the first semiconductor structure 103, and/or the aluminum content of the second confinement layer 104b may gradually increase from a side close to the first well layer 104c2 to another side close to the second semiconductor structure 105. The gradient variation of the aluminum content of the first confinement layer 104a and/or the second confinement layer 104b can improve mobility of the electrons and reduce the forward voltage of the semiconductor device 10.

Similarly, the aluminum content of the first barrier layer 104c1 may also have a gradient variation. As shown in FIG. 1C, each of the first barrier layers 104c1 in the first active layer 104c has a first side s1 close to the first semiconductor structure 103 and a second side s2 opposite to the first side s1, and the aluminum content of the first barrier layer 104c1 may gradually increase or decrease from the first side s1 to the second side s2. In some embodiments, the aluminum content of the first barrier layer 104c1 may gradually increase first and then gradually decrease from the first side s1 to the second side s2. In some embodiments, the maximum aluminum content in the first barrier layer 104c1 can be located at the middle of the first barrier layer 104c1, or close to the first side s1, or close to the second side s2. When the aluminum content of the first barrier layer 104c1 has a gradient variation, it may vary within a range between 0 to 0.25. For example, the aluminum content of the first barrier layer 104c1 may increase from 0 to 0.25 and then decrease to 0. The gradient variation of the aluminum content of the first barrier layer 104c1 can be a linear change or a step-like change. The band structure of the first barrier layer 104c1 can be adjusted by the aluminum content gradient variation, so that electrons can more easily cross the first barrier layer 104c1 and the forward voltage of the semiconductor device 10 can be reduced.

In some embodiments, the first barrier layer 104c1 has a first thickness t1, and the first well layer 104c2 has a second thickness t2. The first thickness t1 may be greater than or equal to the second thickness t2. According to different purposes of applying the semiconductor device 10, the first thickness t1 may be increased to improve the reliability of the semiconductor device 10 or be reduced to lower the forward voltage of the semiconductor device 10. In some embodiments, the second thickness t2 may be adjusted to modify a shape of the light emission spectrum of t the semiconductor device 10. The first thickness t1 can be in a range of 5 nm to 50 nm, such as 5 nm, 10 nm, 20 nm, 30 nm, 40 nm, or 50 nm. The second thickness t2 can be in a range of 2 nm to 20 nm, such as 2 nm, 5nm, 10 nm, 15 nm or 20 nm. In some embodiments, each of the plurality of first well layers 104c2 has the same thickness. In some embodiments, the first well layer 104c2 disposed between the first barrier layer 104c1 and the first confinement layer 104a (or the second confinement layer 104b) has a thickness greater than that of the first well layer 104c2 disposed between two adjacent first barrier layers 104c1 so that the power of the semiconductor device 10 may be enhanced.

In some embodiments, the first confinement layer 104a and the second confinement layer 104b may have the same or different thicknesses. In some embodiments, the first confinement layer 104a and the second confinement layer 104b may respectively have a thickness greater than both the first thickness t1 and the second thickness t2.

Referring to FIG. 1B, the first semiconductor layer 106 is disposed between the second semiconductor structure 105 and the first electrode 120. The first semiconductor layer 106 may improve current spreading between the first electrode 120 and the semiconductor stack 102 so as to improve light-emitting uniformity of the semiconductor device 10. The first semiconductor layer 106 and the second semiconductor structure 105 have the same conductivity type, and the first semiconductor layer 106 may have a doping concentration greater than or equal to that of the second semiconductor structure 105. In some embodiments, the doping concentration of the first semiconductor layer 106 may be in a range of 1x10¹⁶/cm³ to 1x10¹⁹/cm³. The first semiconductor layer 106 has a third thickness t3. In some embodiments, the third thickness t3 is in the range of 3 µm to 8 µm, for example, it can be 3 µm, 5 µm,7 µm or 8 µm. In some embodiments, the third thickness t3 of first semiconductor layer 106 may be greater than or equal to the thickness of the second semiconductor structure 105. In some embodiments, the first semiconductor layer 106 has a roughened surface 106a to increase light extraction efficiency of the semiconductor device 10.

In some embodiments, when the light emitted by the first active region 104 has a peak wavelength between 900 nm to 1000 nm (the infrared light), the light may be divided into a first portion in which the wavelength is greater than or equal to 900 nm and less than 1100 nm, and the second portion in which the wavelength is less than 900 nm and larger than 700 nm. The first portion of the light is invisible, and the second portion of the light includes the visible light (red light), so the second portion of the light may be detected by the human eye and cause visual interference. In some embodiments, the first semiconductor layer 106 is able to absorb the second portion of the light and/or the first portion of the light, and the absorption of the first semiconductor layer 106 for the second portion is greater than that for the first portion. As the light emitted from the first active region 104 passes through the first semiconductor layer 106, most of the second portion is absorbed by the first semiconductor layer 106. Thus, by disposing the first semiconductor layer 106, the second portion of the light can be reduced, so that the light emission of the semiconductor device 10 has lower risk of inducing visual interference.

The first semiconductor layer 106 may include a III-V semiconductor material. In some embodiments, the first semiconductor layer 106 may be Alₙ₁Ga₁₋ₙ₁As, where 0.005≤n1<0.2, which can increase absorption to the second portion of the light. For example, the aluminum content x of the first semiconductor layer 106 may be 0.01, 0.03, 0.05, 0.07, or 0.1.

As shown in FIG. 1B, the semiconductor device 10 may optionally include a second semiconductor layer 107 disposed between the first semiconductor layer 106 and the second semiconductor structure 105 to further absorb the second portion of the light emitted by the first active region 104. Specifically, the second semiconductor layer 107 has better absorption for the second portion and/or the first portion of the light than the first semiconductor layer 106, and the absorption of the second semiconductor layer 107 for the second portion is greater than that for the first portion. The second semiconductor layer 107 has a conductivity type same as that of the first semiconductor layer 106, and the second semiconductor layer 107 may have a doping concentration less than or equal to that of the first semiconductor layer 106. In some embodiments, the second semiconductor layer 107 may include a III-V semiconductor material without aluminum. In some embodiments, the second semiconductor layer 107 includes GaAs.

In some embodiments, the second semiconductor layer 107 has a fourth thickness t4 equal to or smaller than the third thickness t3 of the first semiconductor layer 106. The fourth thickness t4 may be in the range of 1 µm to 8 µm, such as 1 µm, 3 µm, 5 µm or 8 µm. In some embodiments, as the first semiconductor layer 106 and the second semiconductor layer 107 may also absorb the first portion of the light, the sum of the third thicknesses t3 and the fourth thickness t4 may be equal to or less than 16 µm to avoid loss of the power of the semiconductor device 10, and may be equal to or larger than 4 µm to ensure absorption effect of the second portion.

A total power of light emission of the semiconductor device 10 can be divided as a first power referring to the light intensity of the first portion and a second power referring to the light intensity of the second portion. Furthermore, the semiconductor device 10 may have a first proportion defined as a ratio of the second power to the total power (a sum of the first power and the second power). The smaller the first proportion, the lower the risk of inducing visual interference. In some embodiments, for avoiding visual interference, the first proportion may be equal to or less than 30%, such as 1%, 5%, 10%, or 20%. In some embodiments, when the semiconductor device 10 is operated at a 1000 mA, the second power can be in a range of 80 mW to 170 mW, such as 80 mW, 100 mW, 150 mW or 170 mW.

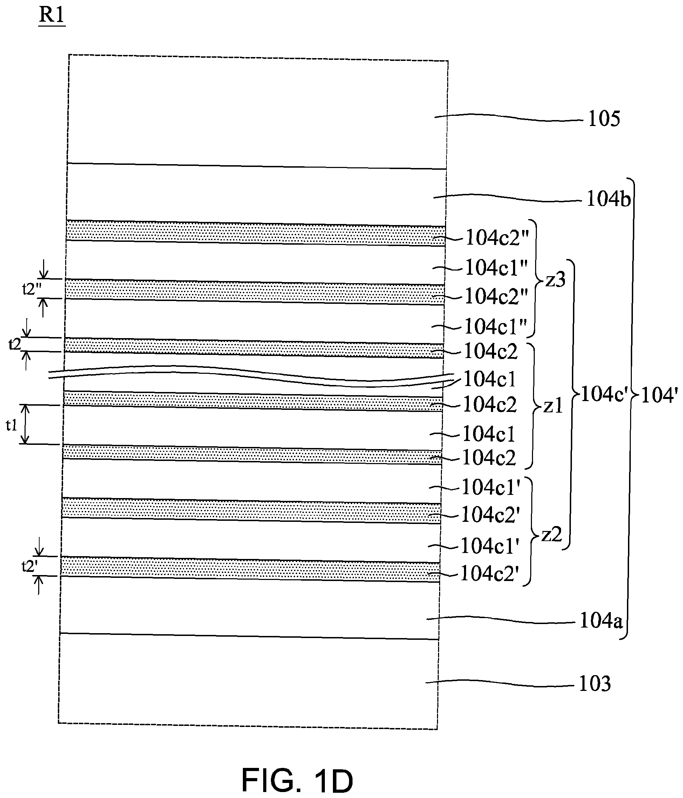

In some embodiments, the first proportion of light emission of the semiconductor device 10 can be reduced by adjusting the structure of the first active region 104. FIG. 1D is a schematic sectional view showing a first active region 104' in accordance with another embodiment of the present disclosure, and the region shown in FIG. 1D is the corresponding to the region R1 in FIG. 1B. As shown in FIG. 1D, the structure of the first active region 104' is similar to the structure of the first active region 104 shown in FIG. 1C, and the main difference therebetween is that the first active layer 104c' of the first active region 104' includes a first zone z1, and may optionally include a second zone z2 and/or a third zone z3. Specifically, the second zone z2 locates between the first zone z1 and the first confinement layer 104a, and the second zone z2 directly connects the first zone z1. The third zone z3 locates between the first zone z1 and the second confinement layer 104b, and the third zone z3 directly connects the first zone z1.

The second zone z2 includes one or a plurality of first barrier layers 104c1' and one or a plurality of first well layers 104c2' which are alternately stacked with each other, and the second thickness t2' of any one of the first well layers 104c2' in the second zone z2 is larger than the second thickness t2 of each of the first well layers 104c2 in the first zone z1. Specifically, each of the first well layers 104c2, 104c2' has multiple energy levels. The electrons will first fill up the low energy levels and then the high energy levels, and during electron-hole recombination the electrons in the high energy level can emit light with a shorter wavelength than the electrons at the low energy level. Since the second zone z2 is closer to the first semiconductor structure 103 than the first zone z1 to have more electrons, the first well layer 104c2' of the second zone z2 is more likely to have electrons filled in the high energy level and emit light of the second portion than the first well layer 104c2 of the first region z1. Increasing the thickness of the first well layer 104c2' in the second zone z2 can move the potential of the high energy level of the first well layer 104c2' closer to the low energy level, thereby increasing the wavelength of the light. As such, the second power or the first proportion of the semiconductor device 10 can be further lowered to reduce visual interference.

In some embodiments, one, multiple or each of the plurality first barrier layers 104c1' in the second zone z2 and one, multiple or each the plurality of the first barrier layers 104c1 in the first zone z1 have substantially the same material composition and/or thickness. For example, both the first barrier layer 104c1' in the second zone z2 and the first barrier layer 104c1 in the first zone z1 may include AlGaAs, AlInP, AlGaAsP or AlGaInP, and each element in both layers has the same ratio, and both layers have the same thickness.

In some embodiments, the number of the first well layers 104c2' in the second zone z2 can be less than the number of the first well layers 104c2 in the first zone z1, and/or the first well layer 104c2' and the first well layer 104c2 may have substantially the same material composition. For example, both the first well layers 104c2 in the first zone z1 and the first well layers 104c2' in the second zone z2 include InGaAs, AlGaInAs or InGaAsP, and each element in both layers has the same ratio.

The third zone z3 includes one or a plurality of first barrier layers 104c1" and one or a plurality of first well layers 104c2'' which are alternately stacked with each other, and the second thickness t2" of any one of the first well layers 104c2'' in the third zone z3 is larger than the second thickness t2 of each of the first well layers 104c2 in the first zone z1. Similarly, increasing the thickness of the first well layer 104c2" in the third zone z3 can further lower the second power and/or the first proportion of the semiconductor device 10 to reduce visual interference.

Similarly, in some embodiments, one, multiple or each of the first barrier layers 104c1'' in the third zone z3 and one, multiple or each of the first barrier layers 104c1 in the first zone z1 have substantially the same material composition and/or thickness. For example, both the first barrier layer 104c1" in the third zone z3 and the first barrier layer 104c1 in the first zone z1 may include AlGaAs, AlInP, AlGaAsP or AlGaInP, and each element in both layers has the same ratio, and both layers have the same thickness. Furthermore, in some embodiments, one, multiple or each of the first barrier layers 104c1 in the first zone z1, one, multiple or each of the plurality first barrier layers 104c1' in the second zone z2 and one, multiple or each of the first barrier layers 104c1" in the third zone z3 may all have substantially the same material composition and/or thickness (i.e., the first thickness t1).

In some embodiments, the number of first well layers 104c2'' in the third zone z3 can be less than the number of first well layers 104c2 in the first zone z1, and one, multiple or each of the first well layers 104c2'' and one, multiple or each of the first well layers 104c2 may have substantially the same material composition. For example, both the first well layers 104c2 in the first zone z1 and the first well layers 104c2'' in the third zone z3 include InGaAs, AlGaInAs or InGaAsP, and each element in both layers has the same ratio. Furthermore, in some embodiments, the first well layer 104c2 in the first zone z1, the first well layers 104c2' in the second zone z2 and the first well layer 104c2'' in the third zone z3 all have substantially the same material composition.

In some embodiments, the second zone z2 may include 1 to 5 pairs (e.g., 1, 2, 3, 4 or 5 pairs) of first barrier layer 104c1' and first well layer 104c2'. The third zone z3 may include 1 to 5 pairs (e.g., 1, 2, 3, 4 or 5 pairs) of first barrier layer 104c1" and first well layer 104c2''. The second power of the semiconductor device 10 may decreases with the increase in the number of the first well layer 104c2' and/or the number of the first well layer 104c2''. The second thickness t2 of the first well layer 104c2, the second thickness t2' of the first well layer 104c2' and the second thickness t2" of the first well layer 104c2'' can be in a range of 2 nm to 20 nm, such as 2 nm, 5nm, 10 nm, 15 nm or 20 nm. In some embodiments, the first thickness t1 can be greater than the second thickness t2', t2".

In some embodiments, a thickness ratio of the first well layer 104c2' to the first well layer 104c2 (t2'/t2) may be in a range of 1.5 and 3. Similarly, a thickness ratio of the first well layer 104c2" to the first well layer 104c2 (t2"/t2) may be in a range of 1.5 and 3. The first well layers 104c2' in the second zone z2 and/or the first well layers 104c2' in the third zone z3 may have the same thickness (as shown in FIG. 1D) or different thicknesses. For example, the second thickness t2' of the first well layers 104c2' in the second zone z2 may gradually increase in a direction towards the first confinement layer 104a (not shown), or the second thickness t2" of the first well layers 104c2'' in the third zone z3 may gradually increase in a direction towards the second confinement layer 104b (not shown).

In some embodiments, increasing the thickness of the first well layers 104c2' and/or the first well layers 104c2" may change the peak wavelength of the light emitted thereby, so the first well layer 104c2' and/or the first well layer 104c2'' may be adjusted the material composition thereof to keep the peak wavelength of light of the first well layers 104c2', the first well layers 104c2'' and the first well layers 104c2 consistent. In some embodiments, the first well layers 104c2, 104c2', 104c2" are the semiconductor material including indium, and the indium content of the first well layers 104c2' and/or the first well layers 104c2'' can be less than that of the first well layers 104c2. In some embodiments, the difference of indium content between the first well layers 104c2', 104c2'' and the first well layers 104c2 can be in a range of 0 to 0.1.

As shown in FIG. 1B, the insulating structure 140, the conductive structure 150, the reflective structure 160 and the bonding structure 170 are located between the semiconductor stack 102 and the base 100. The insulating structure 140 is located between the first semiconductor structure 103 and the base 100 and attached to the first semiconductor structure 103. The conductive structure 150 is located between the insulating structure 140 and the base 100 and attached to the insulating structure 140. The insulating structure 140 and the conductive structure 150 are substantially transparent to the light emitted by first active region 104. For example, the insulating structure 140 and the conductive structure 150 may respectively have a transmittance of at least 80% for the light. The insulating structure 140 has a plurality of holes 141. The conductive structure 150 fills the holes 141 and connect the first semiconductor structure 103 so as to form a contact region in the holes 141. Thereby, the conductive structure 150 can be electrically connected to the semiconductor stack 102. In this embodiment, the holes 141 include a first hole 141a which vertically overlaps with the electrode pad 120a, and a second hole 141b which is not vertically overlaps with the electrode extension 120b and the electrode pad 120a. In other words, the insulating structure 140 is not vertically overlapped with the electrode pad 120a to improve the reliability of the semiconductor device 10. In some embodiments, there are a plurality of second holes 141b vertically located between two adjacent second extension portions 120b2. By adjusting the distribution of the plurality of the second holes 141b, current may uniformly flow in or out the first semiconductor structure 103, and the light-emitting uniformity of the semiconductor device 10 can be improved. In some embodiments, the first hole 141a may have a width greater than that of the second hole 141b.

The insulating structure 140 may be a dielectric layer. For example, the insulating structure 140 includes silicon nitride, aluminum oxide, silicon oxide, magnesium fluoride, titanium oxide (TiOx), niobium pentoxide (Nb₂O₅) or a combination thereof. In some embodiments, the insulating structure 140 may be a single layer or multiple layers. When the insulating structure 140 is a single layer, it has a refractive index of less than 2; when the insulating structure 140 includes multiple layers, the refractive index of each layer may be less than 2. In some embodiments, the insulating structure 140 may include a Distributed Bragg Reflector (DBR) structure. The DBR structure may include a plurality of first dielectric layers and a plurality of second dielectric layers which are alternately stacked with each other, and the first dielectric layers and the second dielectric layers have different refractive indices. In some embodiments, the materials of the first dielectric layer and the second dielectric layer include aluminum oxide (Al₂O₃), silicon dioxide (SiO₂), titanium dioxide (TiO₂) or tantalum oxide (Nb₂O₅).

The conductive structure 150 may include metal or metal oxide. The metal may include silver (Ag), germanium (Ge), gold (Au), nickel (Ni), or a combination thereof. The metal oxide may include indium tin oxide (ITO), indium oxide (InO), tin oxide (SnO), cadmium tin oxide (CTO), antimony tin oxide (ATO), aluminum zinc oxide (AZO), zinc tin oxide (ZTO), gallium zinc oxide (GZO), indium tungsten oxide (IWO), zinc oxide (ZnO), indium zinc oxide (IZO), indium cerium oxide(ICO), indium titanium oxide (ITiO), indium gallium oxide(IGO) or gallium aluminum zinc oxide (GAZO) or a combination thereof.

The reflective structure 160 is located between the conductive structure 150 and the base 100. The reflective structure 160 can reflect the light emitted from the first active region 104 towards the first electrode 120 to exit the semiconductor device 10. In some embodiments, the reflective structure 160 may have a reflectivity more than 80% for the light emitted by first active region 104. The reflective structure 160 may be conductive and include a semiconductor material, a metal or an alloy. The semiconductor material may include a III-V semiconductor material, such as a binary, ternary or quaternary III-V semiconductor material. The metal may include copper (Cu), aluminum (Al), tin (Sn), gold (Au), silver (Ag), titanium (Ti), nickel (Ni), or platinum (Pt). The alloy may include two or more of the above metals. In some embodiments, the reflective structure 160 may include a Distributed Bragg Reflector (DBR) structure. The DBR structure can be formed by alternately stacking two or more semiconductor layers with different refractive indices, such as AlAs/GaAs, AlGaAs/GaAs or InGaP/GaAs.

The bonding structure 170 connects the base 100 and the reflective structure 160. In some embodiments, the bonding structure 170 may be a single layer or multiple layers (not shown). The bonding structure 170 may be electrically conductive and include a metal oxide, a metal or an alloy. The metal oxide includes indium tin oxide (ITO), indium oxide (InO), tin oxide (SnO), cadmium tin oxide (CTO), antimony tin oxide (ATO), aluminum zinc oxide (AZO), zinc tin oxide (ZTO), gallium zinc oxide (GZO), zinc oxide (ZnO), indium cerium oxide (ICO), indium tungsten oxide (IWO), indium titanium oxide (ITiO), indium zinc oxide (IZO), indium gallium oxide (IGO), gallium aluminum zinc oxide (GAZO), or a combination thereof. The metal includes copper (Cu), aluminum (Al), tin (Sn), gold (Au), silver (Ag), lead (Pb), titanium (Ti), nickel (Ni), platinum (Pt) or Tungsten (W). The alloy may include two or more of the above metals.

The protecting structure 180 is disposed on the first electrode 120, the first semiconductor layer 106 and the semiconductor stack 102 so as to avoid forming unwanted electrical path and prevent decay of reliability caused by interaction between the semiconductor stack 102 and external environment. The protecting structure 180 may be transparent to the light emitted from the first active region 104 and having a transmittance of at least 80% for the light. The protecting structure 180 is a dielectric layer, and may include aluminum oxide (AlOₓ), silicon dioxide (SiOₓ), silicon nitride (SiNₓ), silicon oxynitride (SiOₓN_{y}), titanium dioxide (TiOₓ), tantalum oxide (Nb₂O₅) or spin-on glass (SOG). In some embodiments, the protecting structure 180 has a first opening 180a corresponding to the electrode pad 120a for external wires to connect to the electrode pad 120a. In some embodiments, the first opening 180a has a width smaller than that of the electrode pad 120a.

Referring to FIG. 1B, the semiconductor device 10 may optionally include a first contact structure 108 and a second contact structure 109. The first contact structure 108 is located between the first semiconductor structure 103 and the conductive structure 150 to lower the resistance between the first semiconductor structure 103 and the conductive structure 150. The second contact structure 109 is located between the first semiconductor layer 106 and the first electrode 120 to lower the resistance between the first semiconductor layer 106 and the first electrode 120. Thus, the forward voltage of the semiconductor device 10 can be reduced. The first contact structure 108 and the second contact structure 109 may respectively include a single layer or multiple layers of a III-V semiconductor material, metal or alloy. When the first contact structure 108 and/or the second contact structure 109 includes the III-V semiconductor material, the first contact structure 108 has a conductivity type same as that of the first semiconductor structure 103, and the second contact structure 109 has a conductivity type same as that of the second semiconductor structure 105. In some embodiments, the doping concentration of the first contact structure 108 and the second contact structure 109 may respectively be in a range of 1x10¹⁸/cm³ to 1x10²⁰/cm³. In some embodiments, the first contact structure 108 and the second contact structure 109 may respectively include GaAs, GaP or InGaAs.

The first contact structure 108 may be a patterned layer. In some embodiments, the first contact structure 108 includes a plurality of first contact portions 108a separated from each other and located in the second holes 141b without located in the first hole 141a. In other words, the first contact structure 108 is not vertically overlapped with the electrode pad 120a and the electrode extension 120b. In some embodiments, the first contact structure 108 may be a continuous layer (not shown) located between the insulating structure 140 and the first semiconductor structure 103 and has a hole (referring to the first hole 141a) corresponding to the electrode pad 120a. That is, the first contact structure 108 may vertically overlap with the electrode extension 120b without overlapping with the electrode pad 120a. The conductive structure 150 contacts the first contact structure 108 in the second holes 141b, and directly contacts the first semiconductor structure 103 in the first hole 141a. Since the resistance between the first contact structure 108 and the conductive structure 150 is lower than the resistance between the first semiconductor structure 103 and the conductive structure 150, current flows in or out the first semiconductor structure 103 through the second holes 141b instead of the first hole 141a. The first contact structure 108 may have a thickness equal to or smaller than that of the insulating structure 140. In some embodiments, the thickness of the first contact structure 108 may be in a range of 5 nm to 100 nm, such as 5 nm, 10 nm, 20 nm, 50 nm, 75 nm or 100 nm.

The second contact structure 109 may also be a patterned layer. In some embodiments, the second contact structure 109 includes a plurality of second contact portions 109a separated from each other. The plurality of second contact portions 109a is located below the electrode extension 120b without locating below the electrode pad 120a to facilitate current spreading. As shown in FIG. 1B, each of the second contact portions 109a has a width less than that of the second extension portion 120b2, and the second extension portion 120b2 covers a top surface and side surfaces of the second contact portion 109a. In some embodiments, each of the second contact portions 109a has a width equal to that of the second extension portion 120b2 (not shown). In some embodiments, the second contact structure 109 may have a thickness in a range of 50 nm to 80 nm, such as 50 nm, 60 nm, 70 nm or 80 nm. In some embodiments, the electrode extension 120b and the second contact portions 109a directly contact the first semiconductor layer 106.

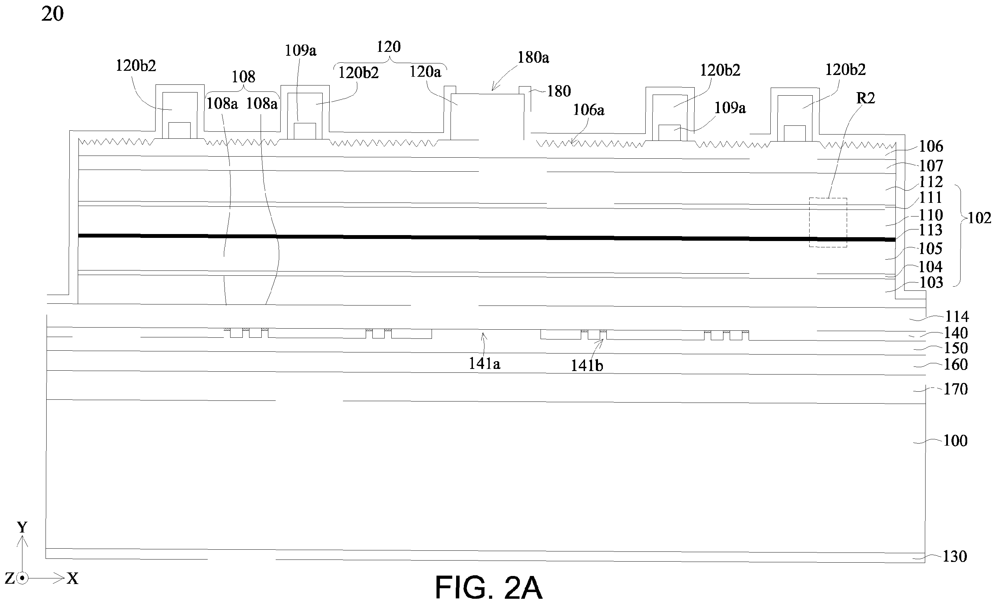

FIG. 2A shows a schematic sectional view of a semiconductor device 20 in accordance with some embodiments of the present disclosure. The semiconductor device 20 has a structure similar to that of the semiconductor device 10, and the main difference between the semiconductor device 20 and the semiconductor device 10 is that the semiconductor stack 102 of the semiconductor device 20 further includes a third semiconductor structure 110, a second active region 111, a fourth semiconductor structure 112 and a tunnel structure 113. In some embodiments, the semiconductor device 20 may optionally include a third semiconductor layer 114 located between the semiconductor stack 102 and the reflective structure160.

As shown in FIG. 2A, the third semiconductor structure 110 is located on the second semiconductor structure 105, the fourth semiconductor structure 112 is located on the third semiconductor structure 110, and the second active region 111 is locate between the third semiconductor structure 110 and the fourth semiconductor structure 112. In some embodiments, the first semiconductor layer 106 (and the second semiconductor layer 107) is located between the fourth semiconductor structure 112 and the first electrode 120. The third semiconductor structure 110 and the fourth semiconductor structure 112 may respectively be a single layer or multiple layers, and may be a cladding layer to limit the recombination of electron-hole pairs to occur in the second active region 111. The third semiconductor structure 110 and the fourth semiconductor structure 112 have different conductivity types. For example, the third semiconductor structure 110 and the fourth semiconductor structure 112 may respectively be n-type and p-type, or p-type and n-type. Thereby, the third semiconductor structure 110 and the fourth semiconductor structure 112 can respectively provide electrons and holes, or holes and electrons, to the second active region 111. In this embodiment, the conductivity type of the third semiconductor structure 110 is different from the conductivity type of the second semiconductor structure 105. That is, the third semiconductor structure 110 and the first semiconductor structure 103 have the same conductivity type, and the fourth semiconductor structure 112 and the second semiconductor structure 105 have the same conductivity type. The material compositions, thicknesses, and doping concentrations of the third semiconductor structure 110 and the fourth semiconductor structure 112 may refer to relative statements of the first semiconductor structure 103 and the second semiconductor structure 105.

The third semiconductor structure 110, the fourth semiconductor structure 112, and the second active region 111 may include the III-V semiconductor material. Specifically, the III-V semiconductor material can be a binary compound semiconductor (such as GaAs, GaP or GaN), a ternary compound semiconductor (such as InGaAs, AlGaAs, InGaP, AlInP, InGaN or AlGaN) or a quaternary compound semiconductor (such as AlGaInAs, AlGaInP, AlInGaN, InGaAsP, InGaAsN or AlGaAsP). In some embodiments, the second active region 111 only include a ternary compound semiconductor (such as InGaAs, AlGaAs, InGaP, AlInP, InGaN, or AlGaN) or a quaternary compound semiconductor (such as AlGaInAs, AlGaInP, AlInGaN, InGaAsP, InGaAsN, or AlGaAsP).

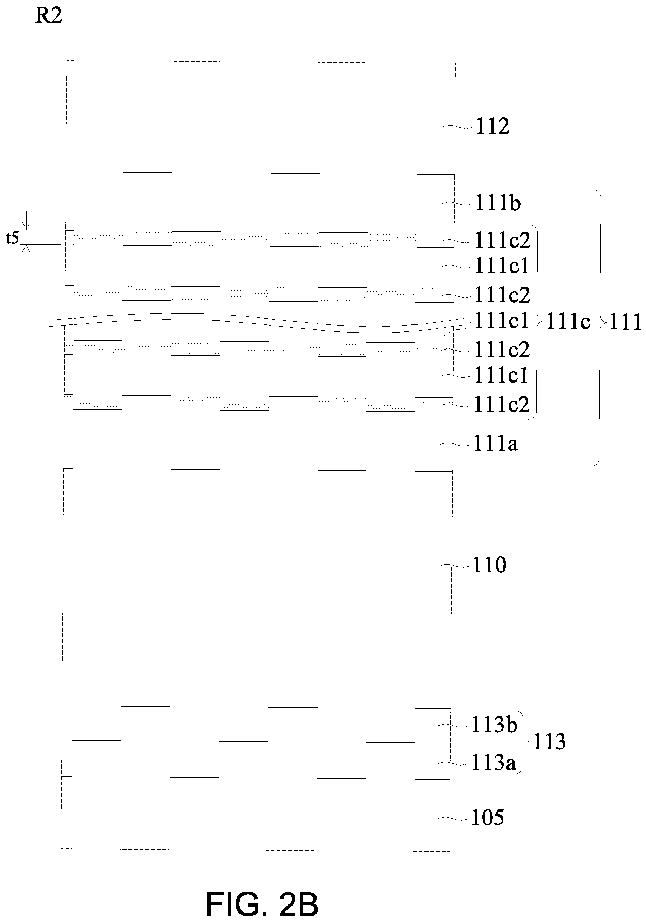

The second active region 111 has a structure similar to that of the first active region 104. FIG. 2B is an enlarged sectional view of a region R2 of the semiconductor device 20 shown in FIG. 2A. The second active region 111 includes a third confinement layer 111a adjacent to the third semiconductor structure 110, a fourth confinement layer 111b adjacent to the fourth semiconductor structure 112, and a second active layer 111c located between the third confinement layer 111a and the fourth confinement layer 111b. In some embodiments, the second active region 111 can be substantially the same as the first active region 104. The third confinement layer 111a and the fourth confinement layer 111b may have substantially the same thicknesses and/or material composition as the first confinement layer 104a and the second confinement layer 104b.

The second active layer 111c includes a second barrier layer 111c1 and a second well layer 111c2. In some embodiments, the second active layer 111c includes a plurality of the second barrier layers 111c1 and a plurality of second well layers 111c2 which are alternately stacked together. The second well layer 111c2 may be disposed between two adjacent second barrier layers 111c1, between the second barrier layer 111c1 and the third confinement layer 111a or between the second barrier layer 111c1 and the fourth confinement layer 111b. The second barrier layer 111c1 and the second well layer 111c2 may respectively have substantially the same quantities, thicknesses, and/or material composition as the first barrier layer 104c1 and the first well layer 104c2. In some embodiments, the second active layer 111c can be substantially the same as the first active layer 104c.

In some embodiments, the second well layer 111c2 includes InGaAs, AlGaInAs or InGaAsP, so the second active region 111 emits the light with a peak wavelength between 900 nm to 1000 nm. The first active region 104 emits a light with a first peak wavelength and the second active region 111 emits a light with a second peak wavelength. In this embodiment, the first peak wavelength and the second peak wavelength are substantially the same, so the semiconductor device 20 is capable of outputting more light than the semiconductor device 10. In some embodiments, a difference of the first peak wavelength and the second peak wavelength is less than 3 nm.

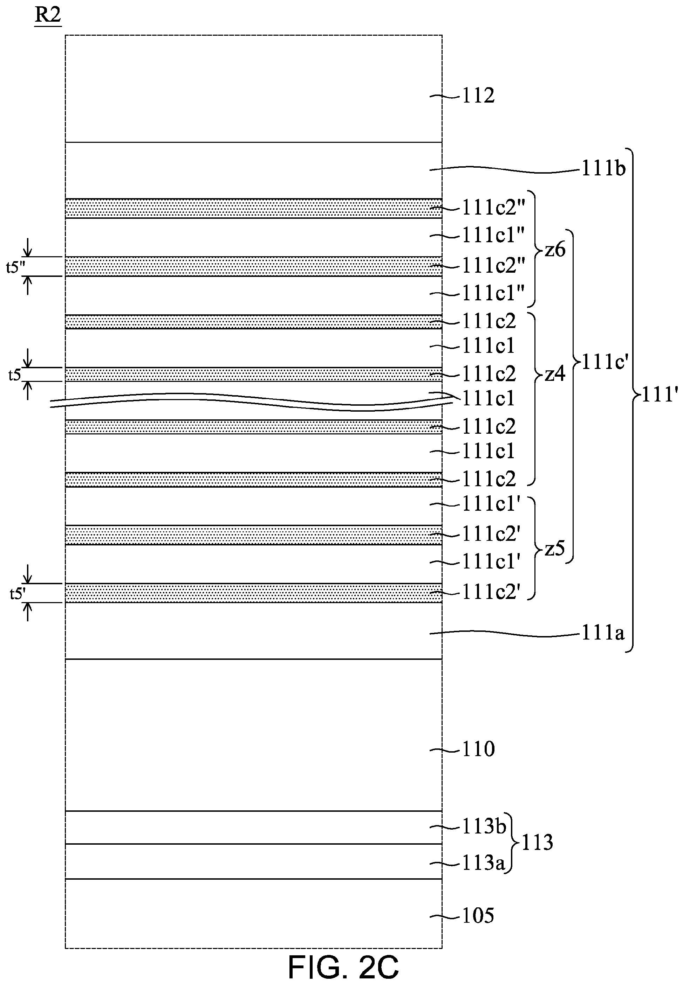

FIG. 2C is a schematic sectional view showing a second active region 111' in accordance with another embodiment of the present disclosure, and the region shown in FIG. 2C is the corresponding to the region R2 in FIG. 2A. As shown in FIG. 2C, the structure of the second active region 111' is similar to the structure of the second active region 111 shown in FIG. 2B, and the main difference therebetween is that the second active layer 111c' of the second active region 111' includes a fourth zone z4, and can optionally include a fifth zone z5 and/or a sixth zone z6.

The fifth zone z5 locates between the fourth zone z4 and the third confinement layer 111a, and directly connects the fourth zone z4. The sixth zone z6 locates between the fourth zone z4 and the fourth confinement layer 111b, and directly connects the fourth zone z4. The fifth zone z5 includes one or a plurality of second barrier layers 111c1' and one or a plurality of second well layers 111c2' which are alternately stacked with each other, and the thickness t5' of any one of the second well layers 111c2' in the fifth zone z5 is larger than the thickness t5 of each of the second well layers 111c2 in the fourth zone z4.

Similarly, the sixth zone z6 includes one or a plurality of second barrier layers 111c1" and one or a plurality of second well layers 111c2" which are alternately stacked with each other, and the thickness t5" of any one of the second well layers 111c2" in the sixth zone z6 is larger than the thickness t5 of each of the second well layers 111c2 in the fourth zone z4. As such, the second power or the first proportion of the semiconductor device 20 can be lower to reduce visual interference. In some embodiments, one, multiple or each the second barrier layers 111c1 in the fourth zone z4, one, multiple or each the second barrier layers 111c1' in the fifth zone z5 and one, multiple or each the second barrier layers 111c1" in the sixth zone z6 may all have substantially the same material composition and/or thickness.

In some embodiments, the number of second well layers 111c2' in the fifth zone z5 and/or the number of second well layers 111c2" in the sixth zone z6 can be less than the number of second well layers 111c2 in the fourth zone z4, and the second well layer 111c2, the second well layer 111c2' and the second well layer 111c2" may all have substantially the same material composition. The second barrier 111c1' and the second well layer 111c2' in the fifth zone z5 may have substantially the same quantities, thicknesses, material composition and/or other characteristics as the first barrier layer 104c1' and the first well layer 104c2' in the second zone z2, respectively. The second barrier layer 111c1" and the second well layer 111c2" in the sixth zone z6 may have substantially the same quantities, thicknesses, material composition and/or other characteristics as the first barrier layer 104c1'' and the first well layer 104c2'' in the third zone z3, respectively. In some embodiments, the second active region 111' shown in FIG. 2C may be substantially the same as the first active region 104' shown in FIG.1D.

In some embodiments, the semiconductor stack 102 of the semiconductor device 20 may include a combination of the first active region 104 and the second active region 111, a combination of the first active region 104 and the second active region 111', a combination of the first active region 104' and the second active region 111, or a combination of the first active region 104' and the second active region 111'.

The tunnel structure 113 is disposed between the second semiconductor structure 105 and the third semiconductor structure 110 for electron transfer between the second semiconductor structure 105 and the third semiconductor structure 110. The tunnel structure 113 has a p-n junction, and includes a first heavily doped layer 113a adjacent to the second semiconductor structure 105 and a second heavily doped layer 113b adjacent to the third semiconductor structure 110. The first heavily doped layer 113a and the second heavily doped layer 113b have different conductivity types. In some embodiments, the first heavily doped layer 113a and the second semiconductor structure 105 have the same conductivity type, while the second heavily doped layer 113b and the third semiconductor structure 110 have the same conductivity type. The tunnel structure 113 may have a doping concentration higher than that of the second semiconductor structure 105 and/or the third semiconductor structure 110. In some embodiments, the doping concentration of the tunnel structure 113 may be higher than or equal to 1x10¹⁹/cm³. The tunnel structure 113 may have a thickness equal to or less than 50 nm to ensure electrons can tunnel through the tunnel structure 113.

Referring to FIG. 2A, the third semiconductor layer 114 is disposed between the first semiconductor structure 103 and the insulating structure 140, and may have a conductivity type same as the first semiconductor structure 103. The third semiconductor layer 114 may include a material composition similar to the first semiconductor layer 106 or the second semiconductor layer 107, and the third semiconductor layer 114 is capable of absorbing the second portion of the light. More specifically, when the light emitted by the first active region 104 and/or the second active region 111 is reflected by the reflective structure 160, the light penetrates the third semiconductor layer 114 and the second portion of the light can be absorbed to further eliminate the visual interference of the semiconductor device 20. In some embodiments, the third semiconductor layer 114 may include Alₙ₂Ga₁₋ₙ₂As, wherein 0≤n2≤0.1, such as 0.01, 0.03, 0.05 or 0.07. In some embodiments, the third semiconductor layer 114 may has a thickness in a range of 0.2 µm to 8 µm. In some embodiments, the third semiconductor layer 114 may have a doping concentration in a range of 1x10¹⁶/cm³ to 1x10¹⁹/cm³.

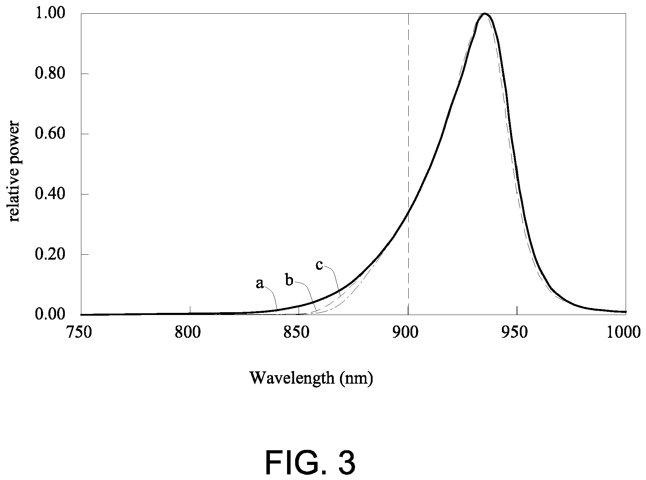

FIG. 3 shows light emission spectrums of different semiconductor devices according to one embodiment of the present disclosure. The horizontal axis represents a wavelength of the light, and the vertical axis represents the relative power of the semiconductor device, in which the maximum power is set as 1. These semiconductor devices have the same structure as the semiconductor device 20, but the aluminum content of the first semiconductor layers 106 thereof are different. Curves a, b and c represent the spectrums of different semiconductor devices in which the aluminum content of the first semiconductor layer 106 are set to be 0.2, 0.04 and 0.03, respectively. It can be seen from FIG. 3 that, as the aluminum content of the first semiconductor layer 106 decreases, the relative power of wavelengths below 900 nm decreases.

According to the spectrums, the total power of the semiconductor device may be represented by an area of the curve between 700 nm to 1000 nm, and the second power of the semiconductor device may be represented by an area of the curve between 700 nm to 900 nm. In this embodiment, the second power of curve b is less than the second power of curve a, and the second power of curve c is less than the second power of curve b. In this embodiment, the first proportions of curve a, curve b and curve c are 15.3%, 13.5% and 12%, respectively. The second power and the first proportion of the semiconductor device decreases with reducing the aluminum content of the first semiconductor layer 106. That is to say, reducing the aluminum content of the first semiconductor layer 106 can enhance absorption effect for the light with a wavelength below 900 nm, i.e., the second portion of the light.

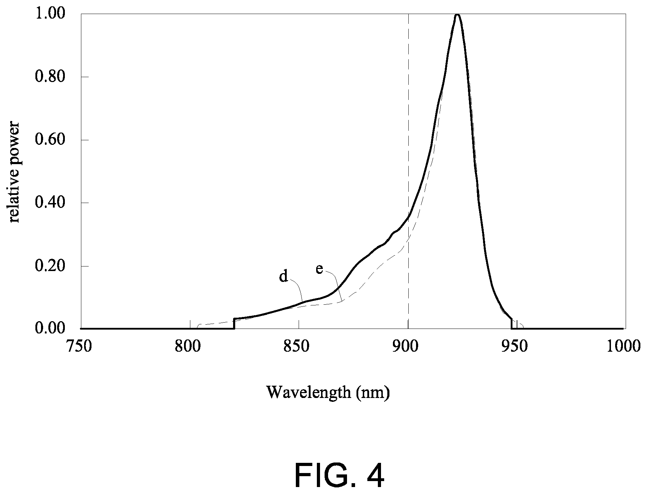

FIG. 4 shows light emission spectrums of different semiconductor devices according to one embodiment of the present disclosure. The semiconductor devices have the same structure as the semiconductor device 20, except for the thicknesses of the first well layer 104c2 and the second well layer 111c2. Curve d represents the spectrum of the semiconductor device in which the thicknesses of the first well layer 104c2 and the second well layer 111c2 are 13 nm, and curve e represents the spectrum of the semiconductor device in which the thicknesses of the first well layer 104c2 and the second well layer 111c2 are 7 nm. It can be seen from FIG. 4 that, as the thicknesses of the first well layer 104c2 and the second well layer 111c2 decrease, the second power of the semiconductor device decreases. In this embodiment, the second power of curve e is less than the second power of curve d. In this embodiment, the first proportions of curve d and curve e are 29.9% and 26.8%. That is, reducing the thickness of the first well layer 104c2 and/or the second well layer 111c2 can lower the second portion of the light and reduce the visual interference.

Reducing the thickness of the first well layer 104c2 and/or the second well layer 111c2 may also reduce the full width at half maximum (FWHM) of the light. More specifically, the FWHM is the distance between two points on the spectrum where the relative light intensity is half of the peak value. In this embodiment, the FWHM of curve e is less than that of curve d, and, with respect to curve d, curve e shrinks at the left side of the peak wavelength, especially between 850 nm to 920 nm. In other words, reducing FWHM of the spectrum may also reduce the second portion of the light and reduce the visual interference.

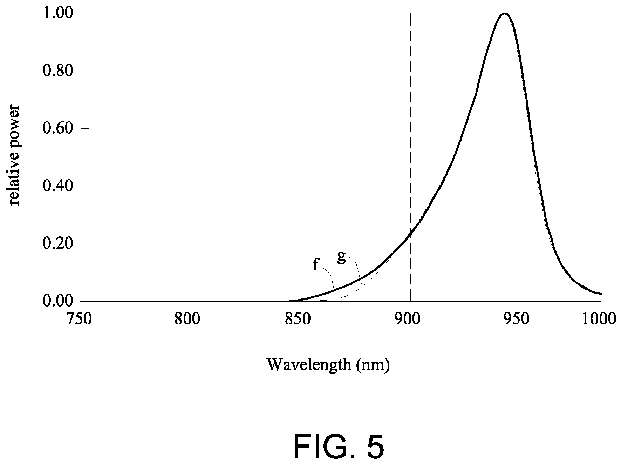

FIG. 5 shows light emission spectrums of different semiconductor devices according to one embodiment of the present disclosure. The semiconductor devices have the same structure as the semiconductor device 20, except of the material and the thickness of the first semiconductor layer 106 and the second semiconductor layer 107. Curve f is the spectrum of a semiconductor device including the first semiconductor layer 106 with 8 µm thickness, and the first semiconductor layer 106 is Al_{0.03}Ga_{0.97}As; curve g is the spectrum of a semiconductor device including the first semiconductor layer 106 with 4 µm thickness and the second semiconductor layer 107 with 4 µm thickness, and the first semiconductor layer 106 and the second semiconductor layer 107 are Al_{0.03}Ga_{0.97}As and GaAs, respectively. It can be seen from FIG. 5 that replacing a part of the first semiconductor layer 106 by the second semiconductor layer 107 can further reduce the second power. In this embodiment, the second power of curve g is less than the second power of curve f. In this embodiment, the first proportion of curve f and curve g are 6.3% and 4.2%. It can be seen that the second semiconductor layer 107 has a better absorption effect on the second portion of light than that of the first semiconductor layer 106.

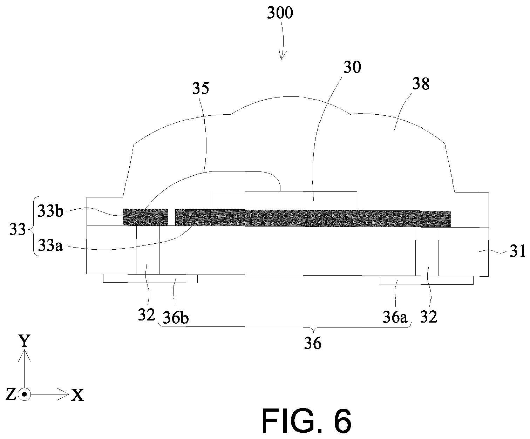

FIG. 6 shows a schematic sectional view of a package structure 300 in accordance with some embodiments of the present disclosure. As shown in FIG. 6, the package structure 300 includes a semiconductor device 30, a package substrate 31, a carrier 33, a bonding wire 35, an electric connecting structure 36 and an encapsulating structure 38. The package substrate 31 may include a ceramic or glass. The package substrate 31 has a plurality of through holes 32. Each through hole 32 may be filled with a conductive material such as metal for electrical conduction and/or heat dissipation. The carrier 33 may be located on a surface of one side of the package substrate 31 and may include a conductive material such as metal. The electric connecting structure 36 is on a surface on another side of the package substrate 31. In some embodiments, the electric connecting structure 36 includes a first contact pad 36a and a second contact pad 36b, and the first contact pad 36a and the second contact pad 36b can be electrically connected to the carrier 33 through the through holes 32. In some embodiments, the electric connecting structure 36 may further include a thermal pad (not shown), for example, between the first contact pad 36a and the second contact pad 36b.

The semiconductor device 30 is located on the carrier 33 and may be the semiconductor device as described in any embodiments of the present disclosure (such as the semiconductor devices 10, 20 and variations thereof). In some embodiments, the carrier 33 includes a first portion 33a and a second portion 33b, and the semiconductor device 30 is located on the first portion 33a and electrically connected to the second portion 33b of the carrier 33 by the bonding wire 35. The material of the bonding wire 35 may include metal, such as gold (Au), silver (Ag), copper (Cu), or aluminum (Al), or may include alloy containing one or more of the above metals. The encapsulating structure 38 covers the semiconductor device 30 and protects the semiconductor device 30. Specifically, the encapsulating structure 38 may include a resin material, such as an epoxy resin, or a silicone resin. The encapsulating structure 38 may further include a plurality of wavelength conversion particles (not shown) to convert a first light emitted by the semiconductor device 30 into a second light. The wavelength of the second light is greater than the wavelength of the first light.

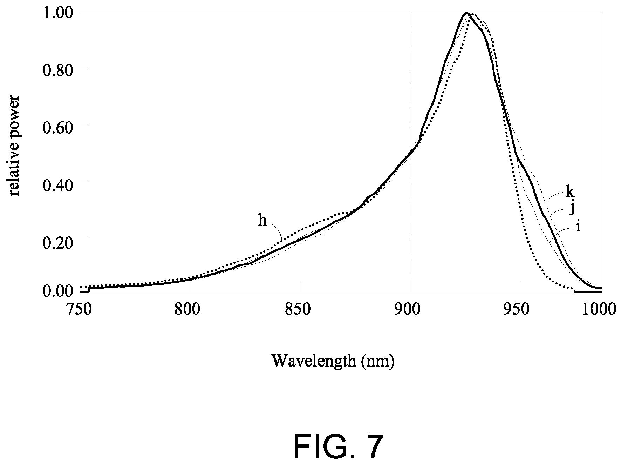

FIG. 7 shows light emission spectrums of different semiconductor devices according to one embodiment of the present disclosure. These semiconductor devices have substantially the same structure as the semiconductor device 20 of FIG. 2A, and have the same number of well layers.

Curve h represents the semiconductor device in which the first active layer 104c do not include the second zone z2 and the second active layer 111c do not include the fifth zone z5, i.e., all the well layers of the first active layer 104c and the second active layer 111c have the same thickness.

Curve i represents the semiconductor device in which the first active layer 104c includes the second zone z2 and the second active layer 111c includes the fifth zone z5, and the second zone z2 and the fifth zone z5 respectively include 3 thickened well layers 104c2', 111c2'.

Curve j represents the semiconductor device in which the first active layer 104c includes the second zone z2 and the second active layer 111c includes the fifth zone z5, and the second zone z2 and the fifth zone z5 respectively include 5 thickened well layers 104c2', 111c2'.

Curve k represents the semiconductor device in which the first active layer 104c includes both the second zone z2 and the third zone z3 and the second active layer 111c includes both the fifth zone z5 and the sixth zone z6, and the second zone z2, the third zone z3, the fifth zone z5 and the sixth zone z6 respectively include 3 thickened well layers 104c2', 104c2", 111c2', 111c2".

In accordance with curves i, j, k of FIG. 7, it can be seen that increasing the thickness of the well layers in the second zone z2 and the fifth zone z5 (and/or the third zone z3 and the sixth zone z6) can reduce the second power and further increase the first power, so that the first proportion of light emission can be reduced. In addition, the first power and the FWHM of the semiconductor device may increase with the increase in the number of thickened well layers.

Based on the above, a semiconductor stack, a semiconductor device or a package structure can be provided in the present disclosure. For example, by adjusting dopant concentrations in the semiconductor stack, improved optical-electrical characteristics, such as capacitance or forward voltage, may be provided. Specifically, the semiconductor stack, the semiconductor device or the package structure of the present disclosure can be applied to products in various fields, such as illumination, medical care, display, communication, sensing, or power supply system, for example, can be used in a light fixture, monitor, mobile phone, tablet, an automotive instrument panel, a television, computer, wearable device (such as watch, bracelet or necklace), traffic sign, outdoor display device, or medical device.

It should be realized that each of the embodiments mentioned in the present disclosure is used for describing the present disclosure, but not for limiting the scope of the present disclosure. Any obvious modification or alteration is not departing from the spirit and scope of the present disclosure. Furthermore, embodiments can be combined or substituted under proper condition and are not limited to specific embodiments described above. A connection relationship between a specific component and another component specifically described in an embodiment can also be applied in another embodiment and is within the scope as claimed in the present disclosure.

## Claims

1. A semiconductor device, comprising:
a base (100);
a semiconductor stack (102) located on the base (100), and comprising a first semiconductor structure (103) adjacent to the base (100), a second semiconductor structure (105) away from the base (100), and a first active region (104) located between the first semiconductor structure (103) and the second semiconductor structure (105);
wherein the first active region (104) comprises a plurality of first well layers (104c2) and a plurality of first barrier layers (104c1) which are alternately stacked with each other; and
a first semiconductor layer (106) located on the second semiconductor structure (105);
wherein the first semiconductor layer (106) comprises Alₙ₁Ga₁₋ₙ₁As, 0.005≤n1<0.2, and has a first thickness in a range of 3 µm to 8 µm; and
wherein the semiconductor device outputs a first power corresponding to a light with a wavelength equal to or larger than 900 nm and less than 1100 nm, and a second power corresponding to a light with a wavelength less than 900 nm and larger than 700 nm, and a ratio of the second power to a sum of the first power and the second power is equal to or less than 30%.

2. The semiconductor device according to claim 1, further comprising a second semiconductor layer located between the first semiconductor layer and the second semiconductor structure, wherein the second semiconductor layer is devoid of aluminum and has a second thickness in a range of 1 µm to 8 µm.

3. The semiconductor device according to claim 1 or 2, wherein each of the plurality of first well layers has a thickness in a range of 2 nm to 20 nm.

4. The semiconductor device according to claim 1, 2 or 3, wherein the semiconductor stack further comprises a third semiconductor structure located between the first semiconductor layer and the second semiconductor structure, a fourth semiconductor structure located between the first semiconductor layer and the third semiconductor structure, and a second active region located between the third semiconductor structure and the fourth semiconductor structure;
wherein the second active region comprises a plurality of second barrier layers and a plurality of second well layers which are alternately stacked with each other.

5. The semiconductor device according to claims 1, 2, 3 or 4, wherein the first active region comprises a first zone and a second zone located between the first zone and the first semiconductor structure, both the first zone and the second zone comprise the first barrier layer and the first well layer, and the first well layer in the second zone has a thickness larger than that of the first well layer in the first zone.

6. The semiconductor device according to claim 5, wherein a ratio of the thickness of the first well layer in the second zone to the thickness of the first well layer in the first zone is in a range of 1.5 to 3.

7. The semiconductor device according to claim 1, wherein the first active region comprises a first zone and a second zone located between the first zone and the first semiconductor structure, and the second zone comprises 2 to 5 pairs of the first barrier layer and the first well layer, and the first well layer in the second zone has a thickness larger than that of the first well layer in the first zone.

8. The semiconductor device according to claim 5 or 7, wherein the first zone directly connects the second zone.

9. The semiconductor device according to claim 5, 7 or 8, wherein the first well layer in the first zone and the second well layer in the second zone have the same material composition.

10. The semiconductor device according to claims 1, 2, 3, 4, 5, 7 or 9 wherein each of the plurality of first well layers comprises indium, and has an indium content which is in a range of 0.02 to 0.4.

11. The semiconductor device according to claims 1, 2, 3, 4, 5 or 7, wherein each of the plurality of first barrier layers comprises aluminum, and has an aluminum content which has a gradient variation.

12. The semiconductor device of any one of the preceding claims, further comprising a reflective structure disposed between the first semiconductor structure and the base.

13. The semiconductor device according to claim 12, further comprising an insulating structure disposed between the reflective structure and the first semiconductor structure.

14. The semiconductor device according to claim 12, further comprising a metal oxide layer disposed between the insulating structure and the reflective structure, wherein the insulating structure comprises a plurality of holes, and the metal oxide layer connects the first semiconductor structure through the plurality of holes.

15. A package structure, comprising:
a package substrate;
the semiconductor device of any one of the preceding claims disposed on the package substrate; and
an encapsulating structure covering the semiconductor device.
